# EUROPÄISCHE PATENTSCHRIFT

(11) **EP 0 516 633 B1**
(45) Veröffentlichungstag und Bekanntmachung des Hinweises auf die Patenterteilung: **14.09.1994**
(21) Anmeldenummer: 91902315.0
(22) Anmeldetag: 22.01.1991
(51) Int. Cl.: G01R 31/00, F02D 41/22, H03K 17/64

(54) **VERFAHREN UND VORRICHTUNG ZUR FUNKTIONSÜBERWACHUNG EINES ELEKTRISCHEN VERBRAUCHERS**
PROCESS AND DEVICE FOR MONITORING THE FUNCTIONING OF AN ELECTRICAL CONSUMER
PROCEDE ET DISPOSITIF DE SURVEILLANCE DE FONCTIONNEMENT D'UN CONSOMMATEUR ELECTRIQUE

(30) Priorität: 22.02.1990 DE 4005609
(43) Veröffentlichungstag der Anmeldung: 09.12.1992
(73) Patentinhaber: ROBERT BOSCH GMBH, 70442 Stuttgart (DE)
(72) Erfinder: JOOS, Eugen, D-7149 Freiberg (DE); BAUER, Eberhard, D-7000 Stuttgart 50 (DE)
(86) Internationale Anmeldenummer: DE9100061
(87) Internationale Veröffentlichungsnummer: WO9113365

(56) Entgegenhaltungen:
- EP-A- 0 195 267
- EP-A- 0 309 753
- WO-A-87/07388
- US-A- 4 178 542

## Beschreibung

### Stand der Technik

Die Erfindung betrifft ein Verfahren und eine Vorrichtung zur Funktionsüberwachung eines von einer Steuerschaltung angesteuerten elektrischen Verbrauchers nach der Gattung der unabhängigen Ansprüche.

Aus der EP-A-0 195 267 ist ein Verfahren und eine Vorrichtung zur Funktionsüberwachung eines von einer Steuerschaltung angesteuerten elektrischen Verbrauchers bekannt. Zur Funktionsüberwachung wird bei dieser Einrichtung die am Verbraucher abfallende Spannung mit einer Spannung verglichen, die abhängig ist von der das Stromsteuerorgan ansteuernden Stromsteuereinrichtung.

Desweiteren ist aus der WO-A-87/07388 ein Verfahren zur Überprüfung von Lastwiderstandskreisen bekannt. Hierzu werden verschiedene Potentiale gemessen und mit Referenzwerten verglichen.

Bei den bekannten Funktionsüberwachungsverfahren erfolgt die Überwachung eines Verbrauchers mit Hilfe einer sogenannten Transistorüberwachung. Dabei kann festgestellt werden, ob der als Schalter dienende Transistor auf "High" oder "Low" ist und ob ein Kurzschluß der Zuleitung des elektrischen Verbrauchers nach der Versorgungsspannung oder nach Masse vorliegt. Erst bei einem höheren Schaltungsaufwand kann zusätzlich eine Unterbrechung der Zuleitung zum Verbraucher erkannt werden.

Auch ist eine Funktionsüberwachung mittels eines Schalter-IC's bekannt. Bei diesem Verfahren ist aber nicht erkennbar, welcher Fehler vorliegt, also ob ein Kurzschluß der zum Verbraucher führenden Leitungen nach der Spannungsversorgung oder nach Masse oder eine Leitungsunterbrechung vorliegt.

Schließlich ist auch ein Verfahren zur Funktionsüberwachung bekannt, bei dem ein intelligentes Diagnose-IC eingesetzt wird. Hierbei sind die Schaltzustände des dem Verbraucher zugeordneten Schalters, Kurzschluß der zum Verbraucher führenden Leitung nach der Versorgungsspannung oder nach Masse sowie eine Leitungsunterbrechung direkt unterscheidbar. Jedoch ist bei einer derartigen Überwachung der Aufwand zur Fehlerkennung sehr hoch. Die Informationen über einen Fehler können codiert, beispielsweise über eine serielle Schnittstelle, auf Anfrage ausgelesen werden.

### Vorteile der Erfindung

Das erfindungsgemäße Verfahren sowie die zugehörige Vorrichtung haben dem gegenüber den Vorteil, daß die Funktion eines elektrischen Verbrauchers bei einem sehr geringem Hardware-Aufwand optimal überwacht werden kann. Dadurch, daß mehrere Vergleichsabfragen zeitlich gestaffelt erfolgen, können Fehler ohne erhöhten Hardware-Aufwand mit hoher Sicherheit erfaßt werden.

Die Vergleichsabfrage wird vor, während und nach einem Schaltereignis durchgeführt. Dabei wird unter einem Schaltereignis der aktive Schaltzustand des von der Steuerschaltung angesteuerten Verbrauchers verstanden. Dadurch kann der Abfragezeitpunkt sehr einfach definiert werden.

Bei einer bevorzugten Ausführungsform des Verfahrens wird, insbesondere zur Erfassung eines Kabelabfalls bzw. einer Leitungsunterbrechung, die Auswertung der Abfrageergebnisse eines Fallsereignisses ausgedehnt auf die Abfrageergebnisse des nachfolgenden Schaltereignisses. Auf diese Weise kann ein Kabelabfall bzw. einer Leitungsunterbrechung besonders einfach von einem Kurzschluß nach der Spannungsversorgung bzw. von einem Kurzschluß nach Masse unterschieden werden.

Weitere Vorteile des Verfahrens ergeben sich aus den übrigen Unteransprüchen.

Bei der erfindungsgemäßen Vorrichtung sorgt eine Zeitsteuerschaltung dafür, daß das Ansteuersignal mit dem Rückmeldesignal zu den gewünschten Zeitpunkten verglichen wird. Ein Kurzschluß nach der Spannungsversorgung bzw. nach Masse ist so sehr einfach feststellbar.

Bei der erfindungsgemäßen Vorrichtung ist ein dem Rückmeldesignal zugeordnetes RC-Glied vorgesehen. Wenn durch eine Abfrage nach dem Schaltereignis ein Fehler festgestellt wird, so können die nachfolgenden Vergleichsabfragen des folgenden Schaltereignisses zur Fehlerauswertung bzw. -bestimmung berücksichtigt werden. Dadurch kann ein Kabelabfall bzw. ein Leitungsbruch von einem Kurzschluß nach der Versorgungsspannung unterschieden werden.

Weitere Vorteile der Vorrichtung ergeben sich aus den übrigen Unteransprüchen. Besonders vorteilhaft ist es dabei, daß für die Funktionsüberwachung lediglich ein sehr geringer Aufwand an Hardware erforderlich ist.

### Zeichnung

Die Erfindung wird im folgenden anhand der Zeichnung näher erläutert. Es zeigen:
- Figur 1: eine Prinzipschaltung einer Vorrichtung zur Funktionsüberwachung eines elektrischen Verbrauchers;
- Figur 2: den Potentialverlauf an der Ausgangsklemme des Steuergeräts, an der Eingangsklemme des elektrischen Verbrauchers sowie des Rückmeldesignals bei verschiedenen Funktionszuständen des elektrischen Verbrauchers;
- Figur 3: eine Vorrichtung zur Überwachung von Einspritzventilen einer Brennkraftmaschine;
- Figur 4: eine Vorrichtung zur Überwachung eines Zweiwicklungsdrehstellers;
- Figur 5: ein Diagramm mit dem Potentialverlauf an den Ausgangsklemmen einer Steuerlogik eines Steuergeräts für einen bidirektionalen Verbraucher und
- Figur 6: ein Diagramm mit dem Verlauf der Potentiale an den Ein- und Ausgangsklemmen der Steuerlogik eines Steuergeräts bei verschiedenen Fehlerfällen bei einem bidirektionalen Verbraucher.

### Beschreibung der Ausführungsbeispiele

Das im folgenden beschriebene Verfahren sowie die Vorrichtung zur Funktionsprüfung eines elektrischen Verbrauchers sind allgemein einsetzbar. Sie können beispielsweise zur Funktionsprüfung von elektrischen Aggregaten eines Kraftfahrzeugs verwendet werden. Diese werden in der Regel von elektrischen Schaltern, beispielsweise von Leistungs-Transistoren angesteuert, wobei der Schalter nach Masse oder zu der Versorgungsspannung gelegt sein kann. Die Funktionsprüfung kann in beiden Fällen vorgenommen werden.

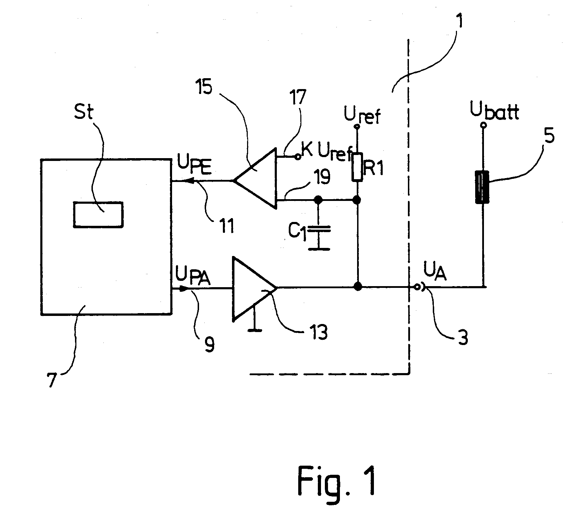

Figur 1 zeigt ein Prinzipschaltbild einer der Funktionsüberwachung dienenden Steuerschaltung 1 mit einer als Steuerklemme 3 bezeichneten Ausgangsklemme. An dieser ist ein mit einer als U_{batt} bezeichneten Versorgungsspannung verbundener elektrischer Verbraucher 5 angeschlossen.

Die Steuerschaltung umfaßt eine interne Steuer- und Auswertelogik 7, die unter anderem einen Ausgangsport 9 und einen Eingangsport 11 aufweist. Zwischen dem Ausgangsport 9 und der Steuerklemme 3 liegt eine Ausgangsstufe 13, die beispielsweise durch einen Leistungstransistor realisiert werden kann. Im aktiven Schaltzustand wird bei diesem Ausführungsbeispiel der Verbraucher 5 von der Ausgangsstufe 13 an Masse gelegt. Die folgenden Ausführungen gelten sinngemäß auch für einen an Masse angeschlossenen Verbraucher, der durch die zugehörige Ausgangsstufe im aktiven Schaltzustand mit der Versorgungsspannung verbunden wird.

Der Eingangsport 11 ist seinerseits über eine Komparatorschaltung 15 mit der Steuerklemme 3 verbunden. Der erste Eingang 17 der Komparatorschaltung liegt an einer Vergleichsspannung U_{ref}, während dessen zweiter Eingang 19 mit der Steuerklemme 3 in Verbindung steht. Dem zweiten Eingang 19 ist ein RC-Glied zugeordnet, dessen Widerstand R1 einerseits an einer Bezugsspannungsquelle U_{ref} und andererseits mit dem zweiten Eingang 19 in Verbindung steht und dessen Kondensator C1 einerseits zum Beispiel an Masse und andererseits ebenfalls an dem zweiten Eingang 19 liegt.

Die Steuerlogik 7 gibt einerseits über den Ausgangsport 9 ein Signal U_{PA} ab, das der Ansteuerung des elektrischen Verbrauchers 5 über die Steuerklemme 3 dient. Andererseits wird von der Steuerklemme 3 ein U_{PE} Signal an die Steuerlogik 7 zurückgemeldet, welches an den Eingangsport 11 der Steuerlogik gelegt wird. Dabei findet eine Auswertung des Rückmeldesignals in der Komparatorschaltung 15 statt.

Die Steuerlogik 7 umfaßt eine Zeitsteuerschaltung St, die die Abfrage der Potentiale an den Ein- und Ausgangsports 9 und 11 sowie an der Steuerklemme 3 des Steuergeräts steuert. Die Zeitsteuerschaltung kann auch durch Software realisiert werden. Die Abfrage wird mit den Schaltereignissen so koordiniert, daß mehrere Abfragen hintereinander erfolgen, vorzugsweise vor, während und nach einem Schaltereignis.

Das durch eine gestrichelte Linie angedeutete Steuergerät 1 ist hier nicht vollständig wiedergegeben. Auf sonst noch vorhandene Verstärkerstufen, Interfaceschaltungen und Schutz-Bauelemente ist hier aus Gründen der besseren Übersichtlichkeit verzichtet worden.

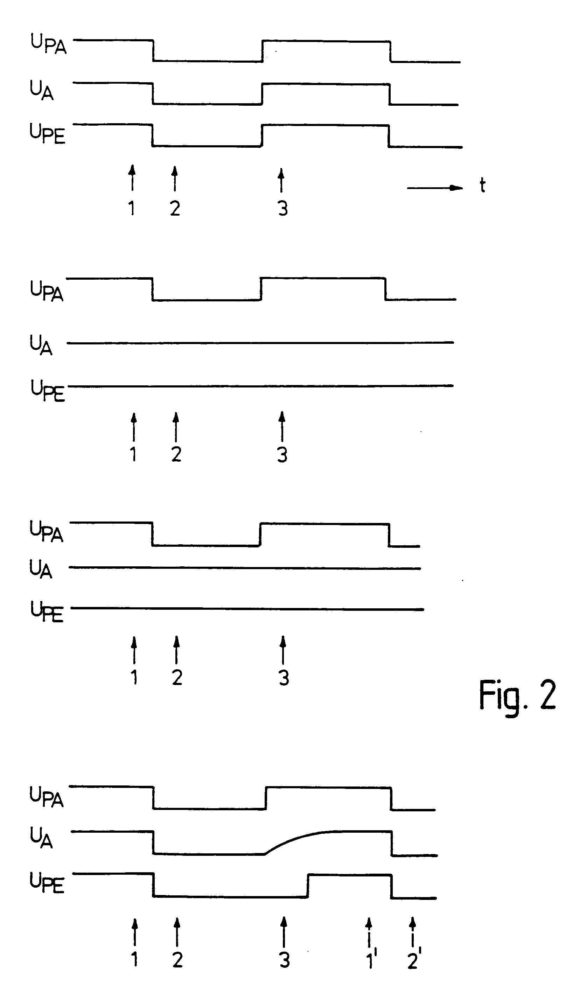

Aus Figur 2 ergibt sich das Prinzip der Funktionsüberwachung. Dazu sind in dieser Figur übereinander vier Diagramme dargestellt, aus denen sich der zeitliche Potentialverlauf an dem Ausgangsport 9, an der Steuerklemme 3 sowie an dem Eingangsport 11 ergibt. Zusätzlich sind mit "1", "2" und "3" bezeichnete Zeitpunkte angedeutet, an denen die Potentiale an den genannten Klemmen abgefragt werden. Das Potential an der Steuerklemme 3 ist mit U_{A}, am Eingangsport 11 mit U_{PE} und am Ausgangsport 9 der Steuerlogik 7 mit U_{PA} gekennzeichnet.

Bei der Darstellung wird davon ausgegangen, daß die Signale zwischen dem Ausgangsport zum Aggregat und zurück zum Eingangsport nichtinvertierend geschaltet werden. Ein Schaltereignis ist hier daran erkennbar, daß an dem Ausgangsport das Potential für einen vorbestimmten Zeitraum abgesenkt wird.

In dem obersten Diagramm in Figur 1 ist der Potentialverlauf für den Fall dargestellt, daß kein Fehler vorliegt. Es zeigt sich, daß die Potentiale am Ein- und Ausgangsport sowie an der Steuerklemme den gleichen Verlauf haben. Daher ergibt sich an den Abfragezeitpunkten "1", "2" und "3" eine logische Übereinstimmung der Signale.

In dem darunterliegenden Diagramm gemäß Figur 2 ist ein Fehlerfall dargestellt, nämlich ein Kurzschluß des Verbrauchers 5 nach Masse. Dadurch ändert sich auch bei einem Potentialwechsel des am Ausgangsport 9 liegenden Ansteuersignals das Potential an der Steuerklemme 3 sowie am Eingangsport 11 nicht. Zu den Abfragezeitpunkten "1", "2" und "3" liegen die Potentiale an der Ausgangsklemme und am Eingangsport 11 der Steuerlogik 7 stets auf Masse.

In dem dritten Diagramm von Figur 2 ist der Potentialverlauf an dem Ausgangsport 9, an der Steuerklemme 3 sowie am Eingangsport 11 dargestellt. Hier ist jedoch ein weiterer Fehlerfall, nämlich ein Kurzschluß des elektrischen Verbrauchers 5 nach der Versorgungsspannung, hier also nach U_{batt}, dargestellt. Es ist erkennbar, daß am Ausgangsport 9 der Steuerlogik 7 ein Schaltereignis stattfindet. Jedoch bleibt das Potential an der Ausgangsklemme 3 unverändert auf U_{batt}. Ebenso ändert sich das Potential am Eingangsport 11 der Steuerlogik 7 nicht; es bleibt ebenfalls unverändert auf U_{batt}.

In dem vierten Diagramm gemäß Figur 2 ist ein weiterer Fehlerfall dargestellt. Außer dem Potentialverlauf an dem Ausgangsport 9 der Steuerlogik 7 ist der Verlauf des Potentials an der Ausgangsklemme 3 sowie an dem das Rückmeldesignal empfangenden Eingangsport 11 dargestellt. Dabei wird hier davon ausgegangen, daß die elektrische Verbindung zwischen dem Steuergerät 1 und dem elektrischen Verbraucher 5 durch einen Kabel-/Steckerabfall oder durch einen Leitungsbruch unterbrochen ist.

Zu den Abfragezeitpunkten "1" und "2" ergeben sich gegenüber dem fehlerfreien Betrieb noch keine Abweichungen. Die Potentiale an der Ausgangsklemme 3 und an dem Eingangsport 11 folgen dem Potential am Ausgangport 9. Wenn jedoch das Potential am Ausgangsport 9 der Steuerlogik 7 auf seinen ursprünglichen Wert zurückgeht, zeigt sich, daß die Potentiale an der Ausgangsklemme 3 sowie am Eingangsport 11 am Ende des Schaltereignisses dem Potential am Ausgangsport 9 nicht unmittelbar folgen. Die Auswertung der Signale führt zu dem Ergebnis, daß zum Abfragezeitpunkt "3" ein Fehlerfall vorliegt, wobei grundsätzlich auch darauf geschlossen werden könnte, daß nun ein Kurzschluß nach Masse vorliegt.

Bei dem Funktionsüberwachungsverfahren wird aufgrund des Fehlers zum Abfragezeitpunkt "3" dafür gesorgt, daß zur genauen Bestimmung des vorliegenden Fehlerfalls die Ergebnisse der Abfrage des nachfolgenden Schaltereignisses zur Bestimmung des vorliegenden Fehlers herangezogen werden. Das heißt, die Abfrageergebnisse zu den Zeitpunkten "1′" und "2′", die den nachfolgenden Schaltereignissen zugeordnet sind, werden zur Auswertung des zum Zeitpunkt "3" vorliegenden Fehlers herangezogen.

Um eine Unterbrechung der Verbindung zwischen dem Steuergerät 1 und dem elektrischen Verbraucher 5 von einem Kurzschluß nach Masse unterscheiden zu können, ist das RC-Glied vorgesehen. Dabei ist der Widerstandswert von R1 wesentlich größer als der Widerstand des an der Ausgangsklemme 3 angeschlossenen elektrischen Verbrauchers. Dies führt dazu, daß sich mit dem Widerstand des elektrischen Verbrauchers eine wesentlich kleinere Aufladezeitkonstante mit dem Kondensator C1 ergibt als mit dem Widerstand R1 des RC-Glieds. Die unterschiedlichen Aufladeverhalten des Kondensators C1 werden von der Komparatorschaltung 15 erfaßt, die einen Schwellwert-Komparator aufweist. Im Fehlerfall ergibt sich eine zeitverzögerte Rückmeldung des Ausschaltvorgangs der Ausgangsstufe 13. Im Zeitpunkt "3" liegt noch keine Bestätigung des Ausschaltvorgangs vor. Diese ergibt sich erst zum Abfragezeitpunkt "1′" des nachfolgenden Schaltereignisses. Aufgrund dieser Zeitverzögerung bei der Bestätigung des Ausschaltvorgangs kann eine Leitungsunterbrechung zwischen Steuergerät 1 und elektrischen Verbraucher 5 sicher unterschieden werden von einem Kurzschluß der Ansteuerklemme 3 nach Masse, wie er im zweiten Diagramm gemäß Figur 2 dargestellt ist.

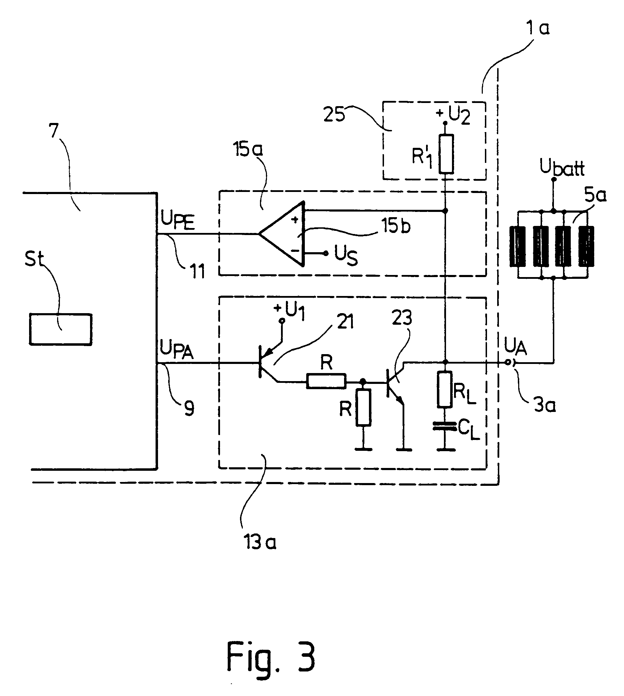

Figur 3 zeigt ein erstes Ausführungsbeispiel einer Vorrichtung zur Funktionsüberwachung eines elektrischen Verbrauchers. Gleiche Teile sind hier mit gleichen Bezugszeichen versehen.

Das hier durch eine gestrichelte Linie angedeutete Steuergerät la dient der Ansteuerung eines elektrischen Verbrauchers 5a über eine Steuerklemme 3a.

Als elektrischer Verbraucher sind hier vier Einspritzventile einer Brennkraftmaschine beispielhaft angedeutet.

Die Steuerlogik 7 steuert über ihren Ausgangsport 9 eine der Ansteuerung der Einspritzventile dienende Ausgangsstufe 13a an. Diese weist einen ersten Transistor 21 auf, dessen Basis mit dem Ausgangsport 9 verbunden ist. Sein Emitter liegt an einer Versorgungsspannung, beispielsweise an +U₁. Sein Kollektor ist über einen zwei Widerstände R aufweisenden Spannungsteiler mit der Basis eines zweiten Transistors 23 verbunden. Diese ist an der Verbindung der beiden Widerstände angeschlossen. Der Spannungsteiler liegt einerseits an dem Kollektor des ersten Transistors 21 und andererseits auf Masse. Ebenso ist der Emitter des zweiten Transistors 23 auf Masse gelegt. Sein Kollektor liegt an der Steuerklemme 3a.

Zur Löschung der induktiven Abschaltspitze der Einspritzventile ist eine Reihenschaltung aus einem Widerstand R_{L} und C_{L} vorgesehen, die zwischen dem Kollektor des zweiten Transistors 23 und Masse liegt. Der Widerstandwert des Widerstands R_{L} ist für die Funktionsüberwachung ohne Bedeutung, da er vernachlässigbar klein ist.

Mit dem das Rückmeldesignal empfangenden Eingangsport 11 der Steuerlogik 7 ist eine Komparatorschaltung 15a verbunden, die einen Komparator 15b aufweist. An dessen ersten Eingang ist eine Verbindung zur Steuerklemme 3a gelegt, an dessen zweiten Eingang eine Schwellwert- bzw. Komparatorspannung U_{S}.

Schließlich ist das Steuergerät la mit einer Zeitkonstanten-Schaltung 25 versehen, die einen an einer Spannungversorgung +U₂ liegenden Widerstand R′₁ umfaßt, der mit der Steuerklemme 3a verbunden ist. Gegenüber dem Widerstand R′₁ ist R_{L} vernachlässigbar klein. Es gilt die folgende Bedingung (R′₁ + R_{L}) >> (R5a + R_{L}), wobei mit R5a der Widerstand des Verbrauchers bezeichnet wird.

Der Widerstand R′₁ der Zeitkonstanten-Schaltung bildet zusammen mit dem Kondensator C_{L} der Löschschaltung in der Ausgangsstufe 13a ein RC-Glied. Dabei entspricht der Kondensator C_{L} dem Kondensator C₁ in Figur 1.

Das Funktionsüberwachungsverfahren mit dem die als elektrischer Verbraucher 5a dienenden Einspritzventile überwacht werden, entspricht dem anhand von Figur 2 erläuterten Verfahren.

Zu gegebenen Zeitpunkten "1", "2" und "3" werden die Potentiale an der Steuerklemme 3a, dem Eingangsport 11 sowie am Ausgangsport 9 der Steuerlogik 7 miteinander verglichen. Sofern die logische Zuordnung stimmt, liegt kein Fehler vor. Ohne weiteres sind Kurzschlüsse zur Versorgungsspannung oder nach Masse unterscheidbar. Dies ergibt sich aus dem zweiten und dritten Diagramm in Figur 2 und den zugehörigen Erläuterungen.

Wenn ein Kabelabfall bzw. eine Leitungsunterbrechung der gemeinsamen Ansteuerleitung der Einspritzventile vorliegt, so kann dies durch das RC-Glied erfaßt werden. Wenn also, wie im untersten Diagramm gemäß Figur 2 zum Abfragezeitpunkt "3" das Potential an der Eingangsklemme 11 noch nicht auf den Ausgangswert zurückgegangen ist, so werden die Potentiale an dieser Klemme und an der Steuerklemme 3a abgefragt und zwar zum Zeitpunkt "1′" des nachfolgenden Schaltereignisses. Auf diese Weise ist ein Kabelabfall eindeutig von einem Kurzschluß nach Masse unterscheidbar.

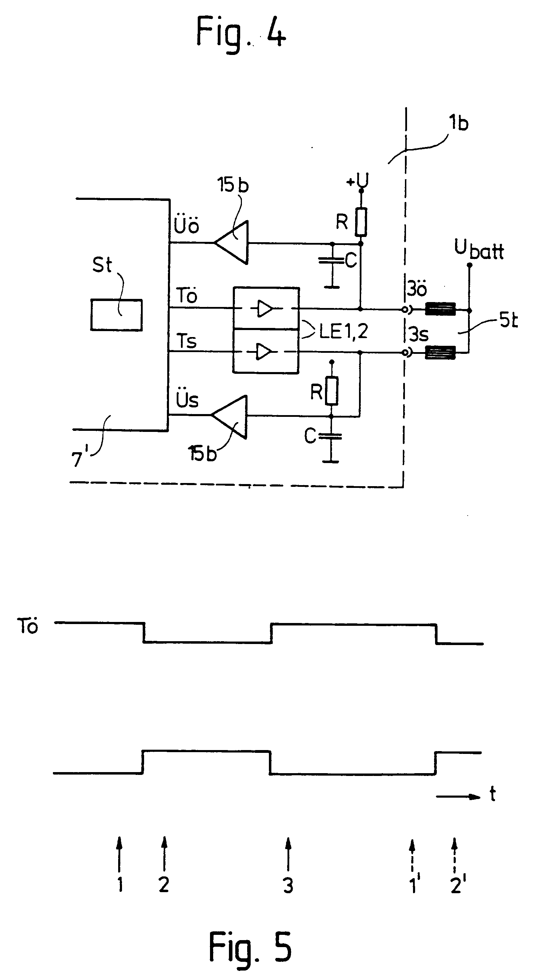

Anhand von Figur 4 wird erläutert, daß das Funktionsüberwachungsprinzip auch bei einem bipolaren Verbraucher, beispielsweise bei einem Zweiwicklungsdrehsteller einsatzfähig ist. Die Ansteuerung dieses Verbrauchers ergibt sich aus dieser Figur, wobei Teile, die mit denen in Figur 1 oder 3 übereinstimmen, mit gleichen Bezugszeichen versehen sind. Auf ihre ausführliche Beschreibung kann hier verzichtet werden.

Das wiederum gestrichelt angedeutete Steuergerät lb weist hier zwei Steuerklemmen 3ö und 3s auf, an denen die Wicklungen eines Zweiwicklungsdrehstellers 5b angeschlossen sind, die andererseits an einer Versorgungsspannung, hier an U_{batt} liegen.

Eine Steuerlogik 7′ weist einen ersten Ausgangs- bzw. Taktport Tö und einen zweiten Ausgangs- bzw. Taktport Ts auf; beide sind Leistungsendstufen LE1 und LE2 zugeordnet. An dem dargestellten Ausführungsbeispiel ist die Leistungsendstufe LE1 mit der Steuerklemme 3ö und die dem Taktport Ts zugeordnete Leistungsendstufe LE2 mit der Steuerklemme 3s verbunden.

Jede der Steuerklemmen ist über eine hier lediglich angedeutete Komparatorschaltung 15b an einen Rückmeldeeingang der Steuerlogik 7′ geführt, dabei ist der Steuerklemme 3ö ein Überwachungseingang Üö und der Steuerklemme 3s ein Überwachungseingang Üs zugeordnet.

Überdies ist den beiden Steuerklemmen 3ö und 3s jeweils ein RC-Glied zugeordnet, wobei eine Reihenschaltung aus einem Widerstand und einem Kondensator einerseits an einer Versorgungsspannung +U und andererseits auch Masse liegt und die Steuerklemme an dem Verbindungspunkt zwischen dem Widerstand und dem Kondensator angeschlossen ist. Die RC-Glieder dienen der Feststellung eines Kabelabfalls bzw. einer Unterbrechung der Zuleitungen zum Verbraucher 5b. Die hier separat vorgesehenen Kondensatoren können dann entfallen, wenn beispielsweise Löschschaltungen vorgesehen sind, die ihrerseits einen HF-Signale und Störspitzen vermeidenden Kondensator aufweisen.

Statt der beiden getrennten Ausgangsports Tö und Ts kann ein gemeinsamer Ausgangsport T vorgesehen werden, dessen Ausgangssignal unmittelbar an die eine Leistungsendstufe, beispielsweise an LE1, geführt wird, und dessen Ausgangssignal über einen Inverter an die andere Leistungsendstufe, also LE2, zugeführt wird.

Auch ist es möglich, anstelle der beiden Eingangsports Üö und Üs einen gemeinsamen mit den Rückmeldesignalen der Steuerklemmen 3ö und 3s beaufschlagten Eingangsport der Steuerlogik 7′ vorzusehen. Dabei kann eine Gewichtung der Ausgangssignale der Komparatoren über geeignete Widerstandswerte erfolgen.

Die Funktionsüberwachung bei dieser Schaltung erfolgt grundsätzlich nach dem oben beschriebenen Verfahren. In Figur 5 sind die Abfragezeitpunkte "1", "2" und "3" über dem Potentialverlauf an den Taktports Tö und Ts aufgetragen. Aus Figur 5 ist ersichtlich, daß die Potentiale an den Taktports Tö und Ts gegenläufig sind. Bei dem ersten Spannungsabfall am Taktport Tö wird das erste Schaltereignis dadurch eingeleitet, daß ein Timer geladen wird. Nach einer vorgegebenen Zeit geht das Potential an Tö auf seinen Ursprungswert zurück, das erste Schaltereignis ist beendet. Der invertierte Potentialverlauf ergibt sich für Ts.

Zum Abfragezeitpunkt "2" kann ein Kabelabfall von Ts erkannt werden, wenn nämlich das Potential an Ts nicht rechtzeitig auf den vorgegebenen Wert ansteigt. Umgekehrt kann zum Abfragezeitpunkt "3" ein Kabelabfall an dem Port Tö festgestellt werden, wenn das Potential den zu diesem Zeitpunkt vorgegebenen Wert nicht erreicht. Für diesen Fall wird, wie oben beschrieben, daß Ergebnis der Abfragezeitpunkte "1′" und "2′" des nachfolgenden Schaltereignisses zur Auswertung dieses Fehlerfalls herangezogen.

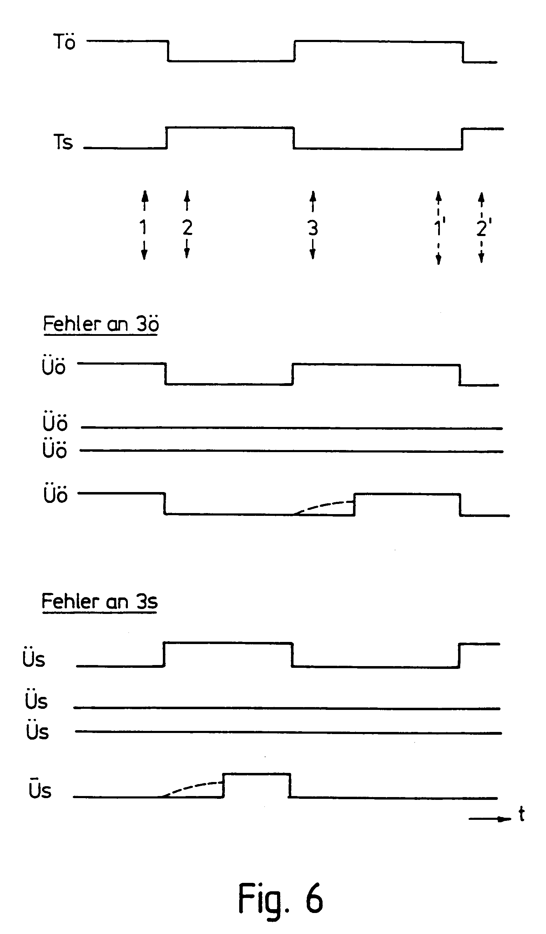

In Figur 6 ist zur Darstellung der verschiedenen Fehlermöglichkeiten der Potentialverlauf an dem Taktport Tö und Ts gemeinsam mit dem Verlauf der Potentiale an dem Eingangsport Üö und Üs dargestellt. In das Diagramm sind die Abfragezeitpunkte "1", "2" und "3" für ein erstes Schaltereignis eingetragen; überdies die Abfragezeitpunkte "1′" und "2′" für ein weiteres Schaltereignis. Bei dem obersten Diagramm der Potentiale am Port Üö ist der Fall eingezeichnet, bei dem weder ein Kurzschluß nach Masse oder zur Spannungsversorgung noch ein Kabelabfall gegeben ist. Das zweite Diagramm zeigt einen Kurzschluß nach Masse, das Dritte einen Kurzschluß zur Versorgungsspannung, beispielsweise zur Batteriespannung eines Kraftfahrzeugs. Schließlich ist im untersten Diagramm der Klemme Üö der Potentialverlauf bei einem Kabelabfall wiedergegeben.

Unten im Diagramm gemäß Figur 6 ist der Potentialverlauf an der Klemme Üs wiedergegeben, wobei im obersten Diagramm kein Fehler vorliegt, im zweiten Diagramm ein Kurzschluß nach Masse gegeben ist, im dritten Diagramm ein Kurzschluß zur Versorgungsspannung. Schließlich ist im untersten Diagramm der Potentialverlauf wiedergegeben, wie er sich bei einem Abfall des Verbindungskabels zum Verbraucher einstellt. Gestrichelt ist der Potentialverlauf am Kondensator des RC-Glieds eingetragen.

Die Unterscheidung der einzelnen Fehlerfälle ist hier ohne weiteres möglich. Das Prinzip der Funktionsüberwachung ist grundsätzlich gleich wie bei der Schaltung gemäß Figur 1. Insbesondere werden auch hier die Abfrageergebnisse eines nachfolgenden Schaltereignisses ausgewertet, wenn zum Zeitpunkt "3" des ersten Schaltereignisses ein Fehler festgestellt wird. Die verzögerte Rückmeldung des Schaltereignisses beruht auf der Wirkung des RC-Glieds. Es gilt hier das zu Figur 2 Gesagte.

Nach allem ist erkennbar, daß für die verschiedenen Einsatzvarianten des Funktionsüberwachungsverfahrens bzw. der Vorrichtung zur Funktionsüberwachung eines elektrischen Verbrauchers alle Fehler, also ein Kurzschluß nach Masse oder zur Versorgungsspannung sowie eine Unterbrechung der Zuleitung zum elektrischen Verbraucher erfaßt werden können. Dabei ist eine eindeutige Unterscheidung der verschiedenen Fehlerfälle möglich. Es ist ohne weiteres erkennbar, daß der Aufwand zur Erkennung und Unterscheidung der Fehler relativ gering ist. Es ist sogar möglich, eine vorhandene Schaltung mit geringem Aufwand so zu ergänzen, daß die Fehlerfälle einfach unterscheidbar sind.

Durch den einfachen Aufbau der Fehlererkennungsschaltung ist sichergestellt, daß die Wahrscheinlichkeit zusätzlicher Fehler aufgrund der Funktionsüberwachungsschaltung gering ist.

Es zeigt sich auch, daß zur Erkennung und Unterscheidung der verschiedenen Fehlerfälle nur ein Port der Steuerlogik belegt zu werden braucht. Dabei ist es für das Verfahren bzw. die Vorrichtung belanglos, ob es sich um einen analogen oder digitalen Port der Logikschaltung handelt. Dabei ist es nicht erforderlich, daß dieser Port als Interrupt-Port ausgelegt ist.

## Patentansprüche

1. Verfahren zur Funktionsüberwachung eines von einer Steuerschaltung (1) angesteuerten elektrischen Verbrauchers (5;5a;5b) durch Vergleich eines der Ansteuerung des Verbrauchers (5,5a,5b) dienenden Signals (UPA) und eines der Steuerschaltung (1) zugeleiteten Rückmeldesignals (UPE), dadurch gekennzeichnet, daß das Rückmeldesignal (UPE) von einem zwischen Versorgungsspannung und Masse liegenden RC-Glied (C1, R1; R1′; RL, CL; R, C) beeinflußt wird, und daß zur Erkennung eines Kurzschlußes des Verbrauchers (5; 5a; 5b) gegen Masse, gegen Versorgungsspannung oder einer Unterbrechung einer Leitung zwischen der Steuerschaltung (1) und dem Verbraucher (5; 5a; 5b) wenigstens je eine Vergleichsabfrage zeitlich gestaffelt vor, während und nach einem Schaltereignis des Verbrauchers (5; 5a; 5b) erfolgt.

2. Verfahren nach Anspruch 1, dadurch gekennzeichnet, daß zur Auswertung eines während eines Schaltereignisses eintretenden oder vorhandenen Fehlers die Vergleichsabfrage des nachfolgenden Schaltereignisses mit berücksichtigt wird.

3. Verfahren nach einem der Ansprüche 1 und 2, dadurch gekennzeichnet, daß die Abfragezeitpunkte von der Steuerschaltung (1) vorgegeben werden.

4. Verfahren nach einem der Ansprüche 1 bis 3, dadurch gekennzeichnet, daß als elektrischer Verbraucher ein Einspritzventil (5a) verwendet wird.

5. Verfahren nach einem der Ansprüche 1 bis 4, dadurch gekennzeichnet, daß als elektrischer Verbraucher ein bidirektional wirkendes Aggregat (5b) verwendet wird, dem sowohl das Ansteuersignal als auch das invertierte Ansteuersignal zugeordnet wird.

6. Verfahren nach Anspruch 5, dadurch gekennzeichnet, daß als Aggregat ein ZweiwicklungsdrehsteIler (5b) verwendet wird.

7. Vorrichtung zur Funktionsüberwachung eines von einer Steuerschaltung (1) angesteuerten elektrischen Verbrauchers (5; 5a; 5b) durch Vergleich eines der Ansteuerung des Verbrauchers (5; 5a; 5b) dienenden Signals (UPA) und eines der Steuerschaltung (1) zugeleiteten Rückmeldesignales (UPE), dadurch gekennzeichnet, daß ein zwischen Versorgungsspannung und Masse angeordnetes RC-Glied (R1, C1; R1′, RL, CL; R, C) dazu dient, das Rückmeldesignal (UPE) zu beeinflussen, und daß wenigstens ein Komparator (15, 15a, 15b) vorgesehen ist, der wenigstens je eine Vergleichsabfrage zeitlich gestaffelt vor, während und nach einem Schaltereignis des Verbrauchers durchführt, ferner eine Steuerlogik (ST) zur Auswertung der Vergleichsabfragen im Hinblick auf Kurzschluß des Verbrauchers (5; 5a; 5b) gegen Masse, gegen Versorgungsspannung oder eine Unterbrechung einer Leitung zwischen der Steuerschaltung (1) und dem Verbraucher (5; 5a; 5b).

8. Vorrichtung nach Anspruch 7, dadurch gekennzeichnet, daß das RC-Glied (R1′, RL, CL) zum Teil durch die Ansteuerschaltung des Verbrauchers (5a) realisierbar ist.

## Claims

1. Method for functional monitoring of an electrical load (5; 5a; 5b), controlled by a control circuit (1), by comparing a signal (UPA) which is used to control the load (5; 5a; 5b) and a status signal (UPE) supplied to the control circuit (1), characterized in that the status signal (UPE) is influenced by an RC element (C1, R1; R1′, RL, CL; R, C) connected between the supply voltage and earth, and in that at least in each case one comparison interrogation is carried out, sequentially in time, before, during and after a switching event of the load (5; 5a; 5b), to detect a short-circuit of the load (5; 5a; 5b) to earth, a short-circuit to the supply voltage or a line interruption between the control circuit (1) and the load (5; 5a; 5b).

2. Method according to Claim 1, characterized in that the comparison interrogation of the subsequent switching event is also taken into account for the evaluation of a defect occurring or existing during a switching event.

3. Method according to one of Claims 1 and 2, characterized in that the interrogation times are predetermined by the control circuit (1).

4. Method according to one of Claims 1 to 3, characterized in that an injection valve (5a) is used as the electrical load.

5. Method according to one of Claims 1 to 4, characterized in that a bidirectionally acting unit (5b) is used as the electrical load, to which both the control signal and the inverted control signal are allocated.

6. Method according to Claim 5, characterized in that a two-winding rotary actuator (5b) is used as the unit.

7. Device for functional monitoring of an electrical load (5; 5a; 5b), controlled by a control circuit (1), by comparing a signal (UPA) which is used to control the load (5; 5a; 5b) and a status signal (UPE) supplied to the control circuit (1), characterized in that an RC element (R1, C1; R1′, RL, CL; R, C) arranged between the supply voltage and earth is used to influence the status signal (UPE) and in that at least one comparator (15, 15a, 15b) is provided for at least in each case one comparison interrogation to be carried out, sequentially in time, before, during and after a switching event of the load, there being furthermore provided a control logic device (ST) for evaluating the comparison interrogations with respect to a short-circuit of the load (5; 5a; 5b) to earth, a short-circuit to the supply voltage or a line interruption between the control circuit (1) and the load (5; 5a; 5b).

8. Device according to Claim 7, characterized in that the RC element (R1′, RL, CL) can be implemented partially by the control circuit of the load (5a).

## Revendications

1. Procédé de surveillance du fonctionnement d'un consommateur électrique (5, 5a, 5b) commandé par un circuit de commande (1), par comparaison d'un signal (UPA) servant à la commande du consommateur (5, 5a, 5b) et d'un signal de retour (UPE) renvoyé au circuit de commande (1), caractérisé en ce que le signal de retour (UPE) est influencé par un élément RC (C1, R1 ; R1 ; RL, CL ; R, C) branché entre la tension d'alimentation et la masse, et pour déceler un court-circuit du consommateur (5, 5a, 5b) par rapport à la masse, par rapport à la tension d'alimentation ou une coupure d'une ligne entre le circuit de commande et le consommateur (5, 5a, 5b), il y a chaque fois une interrogation de comparaison échelonnée dans le temps, avant, pendant ou après un événement de commutation du consommateur (5 ; 5a ; 5b).

2. Procédé selon la revendication 1, caractérisé en ce que pour exploiter un défaut se produisant ou existant pendant un événement de commutation, l'interrogation de comparaison de l'événement de commutation suivant est prise en compte.

3. Procédé selon l'une des revendications 1 et 2, caractérisé en ce que les instants de l'interrogation sont prédéterminés par le circuit de commande (1).

4. Procédé selon l'une des revendications 1 à 3, caractérisé en ce que le consommateur électrique est un injecteur (5a).

5. Procédé selon l'une des revendications 1 à 4, caractérisé en ce que le consommateur électrique est une unité (5b) à action bidirectionnelle à laquelle est associé à la fois un signal de commande et un signal de commande inversé.

6. Procédé selon la revendication 5, caractérisé en ce que l'unité est un actionneur rotatif à deux enroulements (5b).

7. Procédé pour surveiller le fonctionnement d'un consommateur électrique (5 ; 5a ; 5b) commandé par un circuit de commande, par comparaison d'un signal (UPA) servant à commander le consommateur (5, 5a, 5b) et d'un signal de retour (UPE) envoyé au circuit de commande (1), caractérisé en ce qu'un élément RC (R1, C1 ; R1′, RL, CL ; R, C) sert à influencer le signal de retour (UPE) et au moins un comparateur (15, 15a, 15b) qui exécute au moins une interrogation de comparaison échelonnée dans le temps, avant, pendant et après un événement de commutation du consommateur, ainsi qu'une logique de commande (ST) pour exploiter les interrogations de comparaison et déterminer le court-circuit du consommateur (5, 5a, 5b) par rapport à la masse, par rapport à la tension d'alimentation ou une coupure d'une ligne entre le circuit de commande (1) et le consommateur (5, 5a, 5b).

8. Dispositif selon la revendication 7, caractérisé en ce que l'élément RC (R1′, RL, CL) est constitué en partie par le circuit de commande de l'utilisateur (5a).
